# EUROPEAN PATENT APPLICATION

(11) **EP 2 333 930 A2**
(43) Date of publication of application: **15.06.2011**
(21) Application number: 10015444.2
(22) Date of filing: 08.12.2010
(51) Int. Cl.: H02J 9/06, G06F 1/30

(54) **Server and uninterruptable power supply housed in that server**

(30) Priority: 09.12.2009 JP 2009279901
(71) Applicant: Sanyo Electric Co., Ltd., Osaka 570-8677 (JP)
(72) Inventor: Yamashita, Masanori, Osaka 570-8677 (JP); Kabasawa, Takashi, Osaka 570-8677 (JP); Honma, Hisanori, Osaka 570-8677 (JP)
(74) Representative: Hertz, Oliver

(57) **Abstract**

The main server block (20) houses uninterruptible power supplies (10) that supply 150V-400V DC operating power to the main server block (20) input power supply lines (23) both with and without power outage. An uninterruptible power supply (10) has rechargeable batteries (1) having a voltage specification of 60V or less, an AC/DC converter (2) that converts power input from an external commercial power source (50) to DC and supplies it to the input power supply lines (23), a DC/DC step-down converter (3) that steps-down the AC/DC converter (2) output voltage to the rechargeable battery (1) charging voltage, a DC/DC boost converter (4) that steps-up the rechargeable battery (1) voltage and supplies it to the input power supply lines (23) during power outage, and a charging and discharging control circuit (5) that detects commercial power source (50) outage and switches the DC/DC boost converter (4) to the operating state.

## Description

### BACKGROUND OF THE INVENTION

### 1. Field of the Invention

The present invention relates to a server and uninterruptible power supply (UPS) housed in that server where the server is primarily a large-scale rack-type server with 100kW or more of power consumption, and the uninterruptible power supply is housed in the server to maintain the server in an operating state for a given time period in the event of power outage.

### 2. Description of the Related Art

A server (a computer that provides services used by other computers) is required to ensure normal operation during a power outage. ln particular, since a large-scale server is used to process enormous amounts of information, it is extremely important to insure normal operation even during power outage. To achieve this, an uninterruptible power supply has been developed that is setup outside the server. (Refer to Japanese Laid-Open Patent Publication 2006-42495.) This type of uninterruptible power supply charges rechargeable batteries such as lead-storage batteries and supplies alternating current (AC) to the server to replace the commercial AC power source during power outage. An uninterruptible power supply with this architecture, which is intended to supply power to a 100kW or more large-scale server during power outage, becomes extremely large. Accordingly, an uninterruptible power supply for a large-scale server is installed in a special-purpose room separate from the computer room. This configuration has the drawback that not only does the wiring to connect the uninterruptible power supply to the server become complex; the total power efficiency also becomes low. This is because during power outage, lead-storage battery power is converted by a direct current-to-alternating current (DC-to-AC) inverter to the same type of AC as the commercial power source and supplied to the server. Further, AC input to the server is converted to direct current (DC) with a prescribed voltage by a power supply circuit housed inside the server, and the DC is supplied to a power supply line. Further, since this type of uninterruptible power supply is installed outside the server, it also has the drawback that it is inconvenient to use.

To resolve the drawbacks described above, a backup power supply that can be installed in the bottom section of a server case has been developed. (Refer to Japanese Laid-Open Patent Publication 2003-309935.) The backup power supply of JP 2003-309935 A is shown in Figs. 1 and 2. The backup power supply 100 shown in these figures is connected to the output-side of an equipment power source 110 AC/DC converter 111 and supplies power to the output-side of the equipment power source 110 during power outage. With this circuit configuration, rechargeable battery 101 DC is not converted to AC but rather the voltage is stepped-up to the DC voltage of the power supply line by a boost chopper 102. Consequently, the utilization efficiency of the rechargeable batteries 101 can be increased. In this backup power supply 100, the equipment power source 110 output voltage, which is the voltage of the power supply line 112 input to the server, is 51V-55V, and the full-charge voltage of the rechargeable batteries 101 is set to 48V. In a power outage, rechargeable battery 101 voltage is stepped-up to the 51V-55V of the power supply line 112 by the boost chopper 102 and supplied to the server. This configuration has the characteristic of ease of use with the backup power supply conveniently housed in the server case, but it has the drawback that during power outage it is difficult to supply operating power to the server under the same stable conditions as when there is no power outage. This is because during power outage, power is supplied to the output-side of the equipment power source 110 through output leads 120 connected to the output-side of the backup power supply 100, and the voltage drop across those output leads 120 cannot be neglected. If the backup power supply 100 outputs 700W and the power supply line 112 voltage is 51V-55V, high current on the order of 13A-14A will flow through the output leads 120. Accordingly, the output leads 120 require large diameter lead wires to withstand the high current, and voltage drop proportional to the high current cannot be neglected. Consequently, as a result of this circuit structure, it becomes more difficult to insure stable server operation during power outage as the backup power supply output is increased.

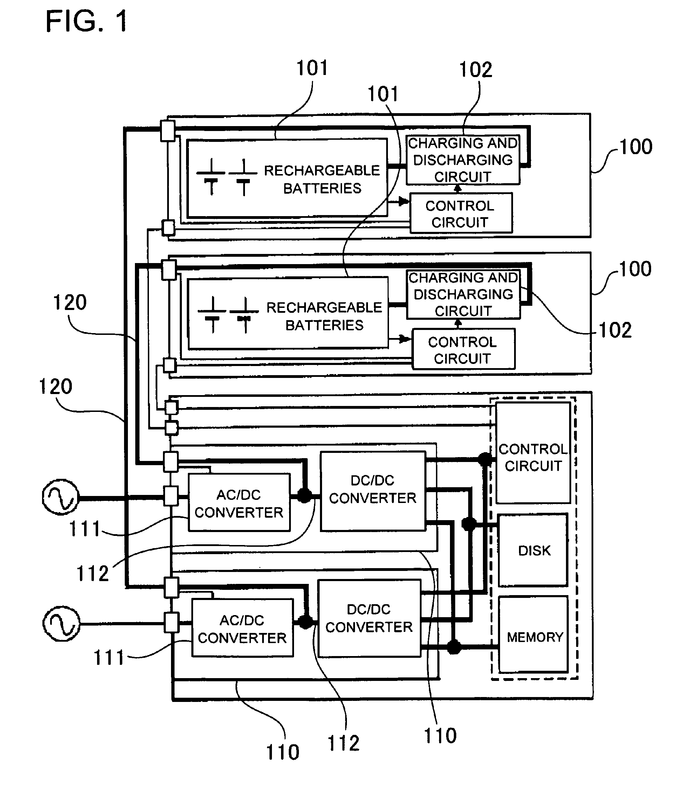

Further, as shown in Fig. 1, when a plurality of backup power supplies 100 supply power to a plurality of equipment power sources 110, it is necessary to connect separate backup power supplies 100 to each equipment power source 110. ln Fig. 1, two backup power supplies 100 are independently connected to two separate equipment power sources 110. Specifically, power cannot be supplied to the overall server equipment by connecting a plurality of backup power supplies 100 in parallel and connecting a plurality of equipment power sources 110 in parallel. This is because the backup power supply 100 supplies power to the equipment power source 110 by stepping-up rechargeable battery 101 voltage with the boost chopper 102. The boost chopper can step-up the rechargeable battery voltage to stabilize the output voltage to a constant voltage, but it cannot achieve constant-current characteristics to limit output current to a fixed value. Accordingly, if a plurality of backup power supplies is connected in parallel, it is not possible to limit the output current of each backup power supply within a fixed range to deliver balanced output. To limit the allowable output current range of each backup power supply, it is necessary to limit the number of equipment power sources connected to each backup power supply. Since this backup power supply requires wiring to connect each backup power supply to a specific equipment power source, power supply wiring becomes complex and troublesome.

### SUMMARY OF THE INVENTION

The present invention was developed with the object of correcting the drawbacks described above. Thus, it is a primary object of the present invention to provide a server and uninterruptible power supply housed in that server to supply stable power from the uninterruptible power supply to the server when power outage occurs as well as when there is no power outage, and to allow stable server operation even during power outage.

Another important object of the present invention is to provide a server and uninterruptible power supply housed in that server to allow continuous stable server operation while simplifying the lead wiring that connects the uninterruptible power supply to the main server block.

The server of the present invention is provided with a main server block 20 that holds a plurality of blade servers 30 and rack servers 31 in a server case 21, and an uninterruptible power supply 10 housed in the server case 21 of the main server block 20 that supplies 150V-400V DC operating power to the main server block 20 input power supply lines 23 both when commercial power source 50 power outage occurs and when there is no power outage. The uninterruptible power supply 10 is provided with rechargeable batteries 1 with a specified voltage of 60V or less that supply operating power to the main server block 20 during commercial power source 50 outage; an AC/DC converter 2 that converts power input from an external commercial power source 50 to DC, supplies charging power to the rechargeable batteries 1, and supplies DC power to the main server block 20 input power supply lines 23; a DC/DC step-down converter 3 that steps-down the AC/DC converter 2 output voltage to the rechargeable battery 1 charging voltage; a DC/DC boost converter 4 with constant voltage output characteristics that steps-up the rechargeable battery 1 voltage and supplies power to the main server block 20 input power supply lines 23 during power outage; and a charging and discharging control circuit 5 that detects commercial power source 50 outage and switches the DC/DC boost converter 4 to the operating state. ln this server, when there is no commercial power source 50 outage, operating power is supplied to the main server block 20 input power supply lines 23 from the AC/DC converter 2. When commercial power source 50 outage occurs, the charging and discharging control circuit 5 detects power outage and puts the DC/DC boost converter 4 in the operating state to supply operating power from the rechargeable batteries 1 to the main server block 20 input power supply lines 23.

The server of the present invention is provided with a plurality of uninterruptible power supplies 10, and the plurality of uninterruptible power supplies 10 can be connected in parallel to the input power supply lines 23 to supply operating power to a plurality of blade servers 30 or rack servers 31.

The server uninterruptible power supply of the present invention is housed in the server case 21 of the main server block 20, which holds a plurality of blade servers 30 and rack servers 31. The uninterruptible power supply supplies 150V-400V DC operating power to the main server block 20 input power supply lines 23 both when commercial power source 50 power outage occurs and when there is no power outage. The uninterruptible power supply is provided with rechargeable batteries 1 with a specified voltage of 60V or less that supply operating power to the main server block 20 during commercial power source 50 outage; an AC/DC converter 2 that converts power input from an external commercial power source 50 to DC, supplies charging power to the rechargeable batteries 1, and supplies DC power to the main server block 20 input power supply lines 23; a DC/DC step-down converter 3 that steps-down the AC/DC converter 2 output voltage to the rechargeable battery 1 charging voltage; a DC/DC boost converter 4 with constant voltage output characteristics that steps-up the rechargeable battery 1 voltage and supplies power to the main server block 20 input power supply lines 23 during power outage; and a charging and discharging control circuit 5 that detects commercial power source 50 outage and switches the DC/DC boost converter 4 to the operating state. ln this uninterruptible power supply, when there is no commercial power source 50 outage, operating power is supplied to the main server block 20 input power supply lines 23 from the AC/DC converter 2. When commercial power source 50 outage occurs, the charging and discharging control circuit 5 detects power outage and puts the DC/DC boost converter 4 in the operating state to supply operating power from the rechargeable batteries 1 to the main server block 20 input power supply lines 23.

The server uninterruptible power supply of the present invention can be provided with an external case 11 having a 1U or 2U size that is housed in the server case 21. The rechargeable batteries 1, AC/DC converter 2, DC/DC boost converter 4, DC/DC step-down converter 3, and charging and discharging control circuit 5 can be housed in the external case 11.

The rechargeable batteries 1 of the server uninterruptible power supply of the present invention can have a specified voltage greater than or equal to 30V and less than or equal to 60V.

The rechargeable batteries 1 of the server uninterruptible power supply of the present invention can a series-connection of a plurality of battery cells 7 that are either nickel hydride batteries or lithium ion batteries.

In the server uninterruptible power supply of the present invention, the external case 11 can be provided with a cooling fan 14 to forcibly ventilate the air inside.

The server and uninterruptible power supply of the present invention have the characteristic that even though the uninterruptible power supply is conveniently housed in the server case of the main server block, stable power can be supplied to the main server block from the uninterruptible power supply both when there is no power outage and when power outage occurs to maintain stable server operation even during power outage. This is because the uninterruptible power supply, which contains rechargeable batteries, is provided with an AC/DC converter that converts commercial power to the input power supply line voltage. ln a power outage, operating power is supplied to the main server block from the rechargeable batteries, and when there is no power outage, operating power is supplied to the main server block from the AC/DC converter. ln addition, the voltage of the input power supply lines is set to a relatively high voltage of 150V to 400V.

Further, the server and uninterruptible power supply of the present invention have the characteristic that the server can be continuously maintained in a stable operating state while simplifying the wiring of leads connecting the uninterruptible power supply to the main server block. This is because the input power supply line voltage is a high voltage of 150V-400V, operating power is supplied from the uninterruptible power supply to the main server block both during power outage and when there is no power outage, and the main server block is maintained in the operating state during power outage with power supplied to the input power supply lines by stepping-up rechargeable battery voltage with a DC/DC boost converter having constant-voltage, constant-current characteristics. By making the input power supply line voltage high, the current can be reduced for a given main server block power consumption to allow lead wire diameter and power loss to be reduced. This has the effect of simplifying the lead wiring. Supplying operating power from the uninterruptible power supply to the main server block both during power outage and when there is no power outage has the effect that stable operating power can be supplied to the main server block under the same conditions during power outage and when there is no power outage. Lastly, supplying rechargeable battery current to the main server block during power outage with a DC/DC boost converter having constant-voltage, constant-current characteristics has the effect of supplying operating power to the main server block in a stable manner.

Further, since rechargeable battery voltage is 60V or less, inexpensive electronic components having a low voltage rating (ability to withstand high voltages) can be used in the DC/DC step-down converter and DC/DC boost converter. Low voltage rating components have low ON-resistance allowing rechargeable battery power to be efficiently supplied to the main server block.

**I**n the present invention, particularly when a plurality of uninterruptible power supplies are installed in the server case, it is unnecessary to independently connect the output of each uninterruptible power supply to the power supply line of each blade server and rack server. The output-side of the DC/DC boost converters can be connected in parallel to supply power to a plurality of blade servers and rack servers. Consequently, this system has the characteristic that even under these multiple-unit conditions, power supply line wiring can be simplified.

Further, by using either nickel hydride batteries or lithium ion batteries as the rechargeable batteries, the uninterruptible power supply can be made small-size and lightweight with high charging capacity to be conveniently housed in the server case. ln addition, the power-out operating time of a server with high power consumption can be extended.

Finally, by forcibly ventilating and cooling the air inside the external case of the uninterruptible power supply of the present invention with a cooling fan, temperature rise in the uninterruptible power supply can be reduced.

The above and further objects of the present invention as well as the features thereof will become more apparent from the following detailed description to be made in conjunction with the accompanying drawings.

### BRIEF DESCRIPTION OF THE DRAWINGS

Fig. 1 is an abbreviated schematic diagram of a prior art backup power supply;

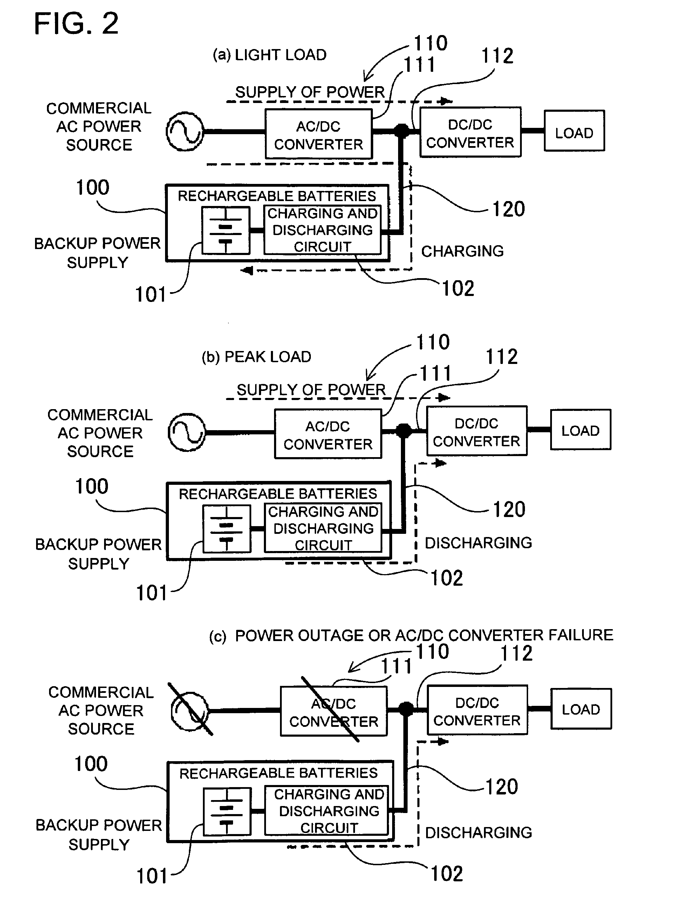

Fig. 2 shows abbreviated diagrams of the use of the backup power supply shown in Fig. 1;
Fig. 3 is an oblique view showing one example of a server for an embodiment of the present invention;
Fig. 4 is a vertical cross-section view of the server shown in Fig. 3;
Fig. 5 is a block diagram of the server shown in Fig. 3;
Fig. 6 is a block diagram of a server for another embodiment of the present invention;
Fig. 7 is a block diagram of a server for another embodiment of the present invention;
Fig. 8 is an oblique view of the uninterruptible power supply for the server shown in Fig. 3; and
Fig. 9 is an exploded oblique view of the uninterruptible power supply shown in Fig. 8 viewed from behind.

### DETAILED DESCRIPTION OF THE EMBODIMENT(S)

The following describes embodiments of the present invention based on the figures.

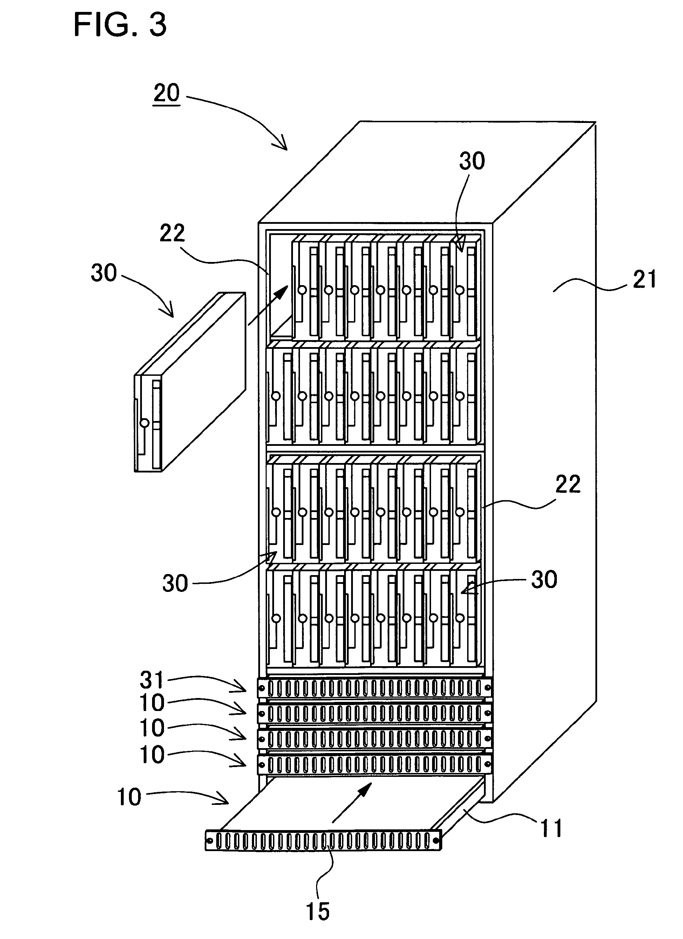

The server shown in Figs. 3-5 is provided with a main server block 20 having a plurality of blade servers 30 and rack servers 31 loaded in a removable manner in a server case 21, and uninterruptible power supplies 10 housed in the main server block 20 server case 21 to supply operating power to the main server block 20 input power supply lines 23 both when there is commercial power source 50 outage and when there is no power outage.

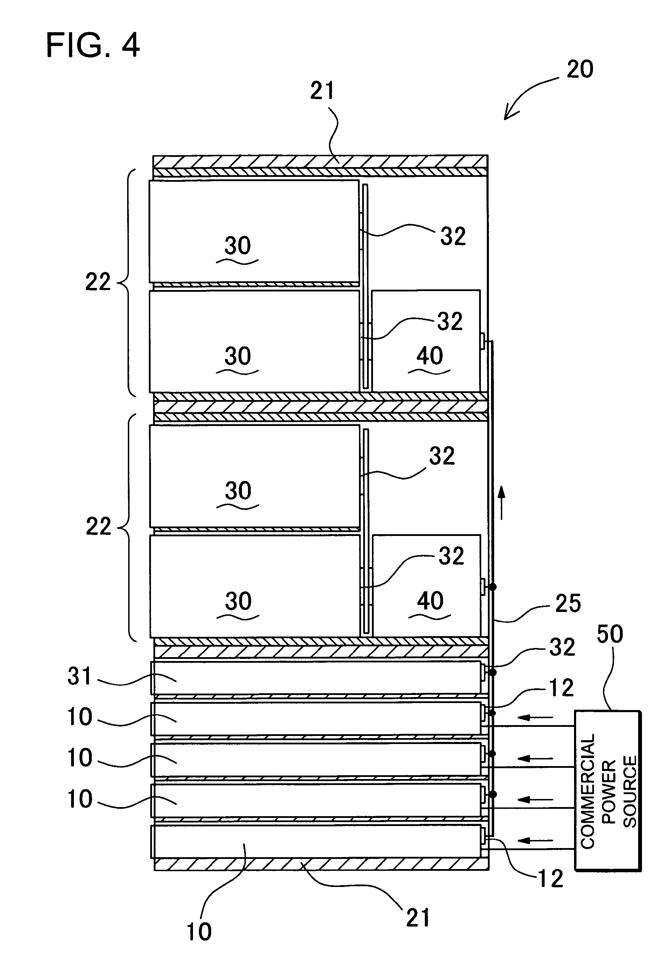

The main server block 20 has a plurality of blade servers 30 housed in enclosures 22, and the enclosures 22 are contained in the server case 21. An enclosure 22 has a plurality of blade servers 30 loaded in a removable manner. The enclosures 22 of Figs. 3 and 4 have a plurality of blade server 30 rows (two rows in the figures) that allow a plurality of columns of blade server 30 to be housed in each row. The server case 21 of the figures is configured to hold a plurality of blade servers 30 loaded in a plurality of enclosures 22 that are loaded in a removable manner. Further, the main server block 20 has rack servers 31 loaded in a removable manner in the bottom section of the server case 21 beneath the enclosures 22. However, the main server block can also house rack servers in the upper section or mid-section of the server case.

Further, the main server block 20 has uninterruptible power supplies 10 loaded in a removable manner in the bottom section of the server case 21 to supply power to the blade servers 30 and rack servers 31. Although the main server block 20 of the figures houses uninterruptible power supplies 10 in the bottom section of the server case 21, the uninterruptible power supplies can also be housed in the upper section of the server case above the plurality of blade servers, or in the mid-section of the server case between the plurality of blade servers. The uninterruptible power supplies 10 supply power to the main server block 20 blade servers 30 and rack servers 31 both during power outage and when there is no power outage. During power outage, the uninterruptible power supplies 10 maintain server operation for a given time period. The time that the uninterruptible power supplies 10 maintain the server in an operational state after power outage occurs is longer than the time required to properly shutdown the server and is, for example, from 2min to 10min.

The server case 21 of the figures houses a plurality of uninterruptible power supplies 10 beneath the enclosures 22 in multiple levels with horizontal orientation. The number of uninterruptible power supplies 10 loaded in the server case 21 is set by the number of uninterruptible power supplies 10 that can maintain the main server block 20 in an operating state both during power outage and when there is no power outage. When the output power of a single uninterruptible power supply 10 is less than the main server block 20 power consumption, a plurality of uninterruptible power supplies 10 is loaded in the server case 21. The output-sides of the plurality of installed uninterruptible power supplies 10 are connected in parallel to supply power to the main server block 20 and keep it in the operating state. For example, a main server block 20 with 10kW power consumption can use four uninterruptible power supplies 10, each with 2.5kW output power, loaded in the server case 21.

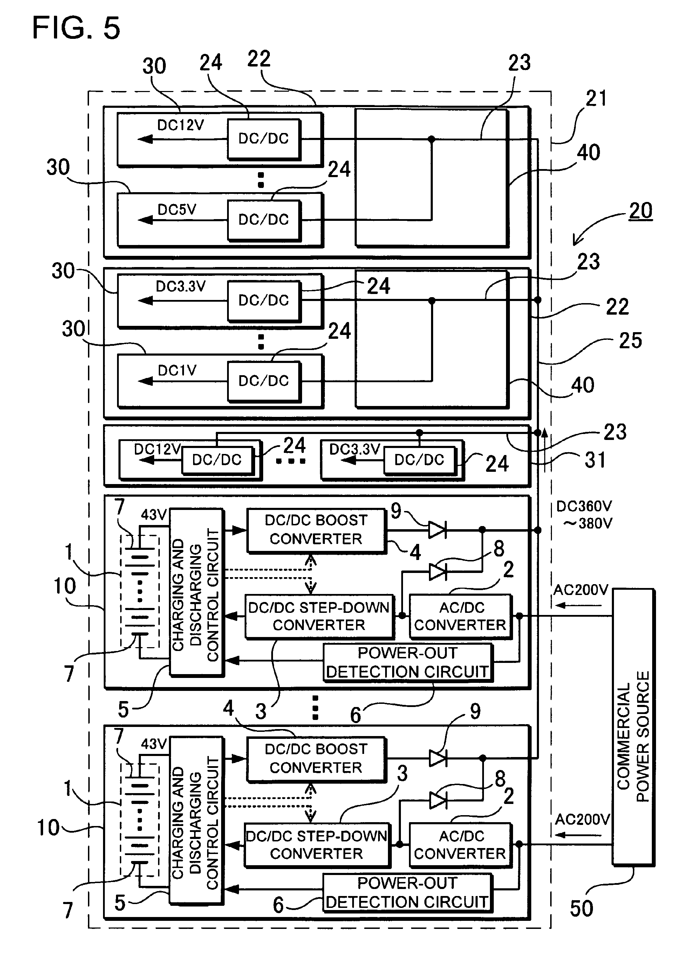

As shown in Fig. 5, a server provided with a plurality of uninterruptible power supplies 10 has the output of each uninterruptible power supply 10 connected in parallel and the plurality of input power supply lines 23 in the main server block 20 also connected in parallel. Specifically, the output of each uninterruptible power supply 10 is not independently connected to each input power supply line 23, but rather the output-sides of the uninterruptible power supplies 10 are connected in parallel to supply power to a plurality of input power supply lines 23. The reason a plurality of uninterruptible power supply 10 outputs can be connected in parallel to supply stable power to a plurality of power supply lines is described in detail later, but in short, it is because uninterruptible power supply 10 output is afforded constant-current characteristics. Since this architecture allows a plurality of uninterruptible power supply 10 outputs and a plurality of input power supply lines 23 to be connected by a single connecting line 25, it has the characteristic that wiring can be simplified.

An uninterruptible power supply 10 has an external case 11 that is loaded in a removable manner in the server case 21 and is provided with a connecting section 12 on the backside. ln the uninterruptible power supply 10 of the figures, the external case 11 is a 1 U size that can be loaded in a removable manner in the server case 21. However, the uninterruptible power supply external case can also be a 2U size. When the external case 11 is loaded in a designated position in the server case 21, the connecting section 12 connects uninterruptible power supply 10 output and communication lines to the main server block 20.

As shown in Figs. 4 and 5, the backside of the server case 21 is provided with interconnect bays 40 that hold wiring such as bus wires, communication lines, and power supply lines 23 connected to blade servers 30, rack servers 31, and uninterruptible power supplies 10 loaded in the server case 21. Blade servers 30, rack servers 31, and uninterruptible power supplies 10 are provided with connecting sections 32, 12 made up of connectors and connecting terminals that connect to the interconnect bays 40. When blade servers 30, rack servers 31, and uninterruptible power supplies 10 are loaded in designated positions in the server case 21, they connect to the interconnect bays 40 by the connecting sections 32, 12.

Fig. 5 shows a block diagram of a server. The server shown in the figure is provided with a main server block 20 having a plurality of blade servers 30 and rack servers 31, and uninterruptible power supplies that supply 150V-400V DC operating power to the main server block 20 input power supply lines 23 both when commercial power source 50 power outage occurs and when there is no power outage. The main server block 20 is provided with DC/DC converters 24 that convert the 150V-400V DC supplied to the input power supply lines 23 to the power supply voltages of the main server block 20. The main server block 20 DC/DC converters 24 are implemented in each blade server 30 and rack server 31 and convert the input power supply line 23 voltage to power supply voltages appropriate for each circuit, for example, 12V, 5V, 3.3V, and 1V.

An uninterruptible power supply 10 is provided with rechargeable batteries 1 with a specified voltage of 60V or less that supply operating power to the main server block 20 during commercial power source 50 outage; an AC/DC converter 2 that converts power input from an external commercial power source 50 to DC, supplies charging power to the rechargeable batteries 1, and supplies DC power to the main server block 20 input power supply lines 23; a DC/DC step-down converter 3 that steps-down the AC/DC converter 2 output voltage to the rechargeable battery 1 charging voltage; a DC/DC boost converter 4 with constant-voltage, constant-current output characteristics that is switched to the operating state to step-up the rechargeable battery 1 voltage and supply power to the main server block 20 input power supply lines 23 during power outage; and a charging and discharging control circuit 5 that detects commercial power source 50 outage and switches the DC/DC boost converter 4 to the operating state.

In the uninterruptible power supply 10 described above, when there is no commercial power source 50 outage, operating power is supplied to the main server block 20 input power supply lines 23 from the AC/DC converter 2. When commercial power source 50 outage occurs, the charging and discharging control circuit 5 detects power outage and puts the DC/DC boost converter 4 in the operating state to supply operating power from the rechargeable batteries 1 to the main server block 20 input power supply lines 23.

The rechargeable batteries 1 are a plurality of battery cells 7 connected in series to attain a total specified voltage that is less than 60V, and for example, is set to 43V. If rechargeable battery voltage is greater than 60V, semiconductor switching devices with a high voltage rating must be used in the DC/DC converters. ln addition to being expensive, ON-resistance and power loss increases for high voltage rating switching devices. Switching device power loss reduces the power efficiency of the rechargeable batteries and limits output to the input power supply lines. Therefore, rechargeable battery specified voltage is set lower than 60V. However, since current increases as the rechargeable battery voltage is reduced, rechargeable battery voltage is preferably set greater than 30V, and ideally greater than 35V.

Nickel hydride batteries or lithium ion batteries are used as the battery cells 7 in the rechargeable batteries 1. **ln** an uninterruptible power supply with nickel hydride batteries used as the rechargeable battery cells, the power supply voltage can be 43V with 36 battery cells connected in series. Further, rechargeable battery 1 current capacity can be increased by increasing the number of battery cells connected in parallel. The number of battery cells 7 connected in series and parallel can be adjusted, for example, to enable the rechargeable batteries 1 to continuously output 2.5kW of power for 2min-10min to the main server block 20 input power supply lines 23.

The AC/DC converter 2 is a power supply circuit with constant-voltage, constant-current output characteristics that converts commercial power source 50 AC to 360V-380V DC, for example. When there is no power outage, the AC/DC converter 2 supplies power to the main server block 20. Accordingly, AC/DC converter output power is determined considering the power consumption of the main server block 20. For example, in a system with four uninterruptible power supplies 10 loaded in the server case 21 of a 10kW main server block 20, the output of the AC/DC converter 2 is made greater than 2.5kW. The AC/DC converter 2 has a reverse-current protection diode 8 connected to the output-side leading to the input power supply lines 23.

Output from the AC/DC converter 2 charges the rechargeable batteries 1. There is no need to rapidly charge the rechargeable batteries 1, and for example, they are charged by a small current less than 1A. Further, since the input power supply line 23 voltage is stepped-down to charge the rechargeable batteries 1, AC/DC converter 2 current used for charging the rechargeable batteries 1 is smaller than the rechargeable battery 1 charging current. For example, when 43V rechargeable batteries 1 are charged with 1A and input power supply line voltage is 380V, the AC/DC converter 2 current used to charge the rechargeable batteries 1 is extremely small on the order of 0.1A. Consequently, AC/DC converter 2 output power is determined primarily considering the power required to operate the main server block 20.

The DC/DC step-down converter 3 steps-down the voltage of the DC supplied to the server input power supply lines 23 and outputs the rechargeable battery 1 charging voltage. The DC/DC step-down converter 3 has output characteristics suitable for charging the rechargeable batteries 1 under the appropriate conditions. Nickel hydride batteries are charged with a constant current, and lithium ion batteries are charged while limiting both current and voltage. Accordingly, in an uninterruptible power supply 10 with nickel hydride battery cells 7, the rechargeable batteries 1 are charged by a DC/DC step-down converter 3 having constant-current characteristics. ln an uninterruptible power supply 10 with lithium ion battery cells 7, the rechargeable batteries 1 are charged by a DC/DC step-down converter 3 having constant-voltage, constant-current characteristics. The output current of the DC/DC step-down converter 3 is extremely low compared to the DC/DC boost converter 4, and is set, for example, to 0.5A-1A. This is because the rechargeable batteries 1 can be charged over a long time period. A DC/DC step-down converter 3 with low output current can be made small and generate little heat. The DC/DC step-down converter 3 is controlled by the charging and discharging control circuit 5 to maintain the rechargeable batteries 1 at a given remaining capacity, for example, 80%-100%. **I**n this example, when rechargeable battery 1 remaining capacity drops to 80%, the DC/DC step-down converter 3 is put in the operating state to begin rechargeable battery 1 charging. When rechargeable battery 1 remaining capacity reaches 100%, DC/DC step-down converter 3 operation is stopped to stop rechargeable battery 1 charging. This is performed repeatedly to maintain rechargeable battery 1 remaining capacity at a given level.

The DC/DC boost converter 4 steps-up the rechargeable battery 1 voltage and outputs the input power supply line 23 voltage. The DC/DC boost converter 4 has constant-voltage, constant-current output characteristics to stabilize output voltage to a constant voltage and limit output current to a constant current. For example, the DC/DC boost converter 4 for a uninterruptible power supply 10 that outputs 2.5kW during a power outage stabilizes the output voltage to 360V-380V and limits output current to 7A to limit the output within a fixed range. The DC/DC boost converter 4 is controlled by the charging and discharging control circuit 5 and put in the operating state when power outage occurs. The activated DC/DC boost converter 4 steps-up the rechargeable battery 1 voltage, and outputs that power to the input power supply lines 23. When there is no commercial power source 50 outage, the DC/DC boost converter 4 is maintained in a non-operating state by the charging and discharging control circuit 5 and the converter itself consumes no power in that state. The DC/DC boost converter 4 has a reverse-current protection diode 9 connected to the output-side.

The charging and discharging control circuit 5 detects rechargeable battery 1 remaining capacity and controls the operating state of the DC/DC step-down converter 3, or controls a charging switch provided on the output-side of the DC/DC step-down converter 3 to continuously maintain rechargeable battery 1 remaining capacity within a set range. When the rechargeable batteries 1 discharge over time and remaining capacity drops below the set range, the charging and discharging control circuit 5 puts the DC/DC step-down converter 3 in the operational state or turns ON a charging switch connected to the output-side of the DC/DC step-down converter 3 to charge the rechargeable batteries 1. When remaining capacity reaches a set value, the charging and discharging control circuit 5 stops operation of the DC/DC step-down converter 3 or switches OFF the charging switch to stop charging.

The charging and discharging control circuit 5 also controls the DC/DC boost converter 4 to prevent the rechargeable batteries 1 from over-discharging. During power outage when the rechargeable batteries 1 are discharging to supply power to the server and remaining capacity drops to a minimum capacity, DC/DC boost converter 4 operation is stopped to stop rechargeable battery 1 discharge.

When the charging and discharging control circuit 5 detects commercial power source 50 outage, it switches the DC/DC boost converter 4 to the operating state. The charging and discharging control circuit 5 does not activate the DC/DC boost converter 4 to the operating state when there is no power outage. Specifically, when there is no power outage, the DC/DC boost converter 4 is maintained in a non-operating (inactive) state. Even under no-load conditions, the DC/DC boost converter 4 consumes considerable power in the operating state. For example, if the DC/DC boost converter 4 consumes 5% of the specified output power under no-load conditions, a DC/DC boost converter 4 with a specified output of 2.5kW will consume 125W of power in the operating state with no load. ln the operating state, this power is continuously consumed as wasted power. To prevent this drawback, the charging and discharging control circuit 5 only switches the DC/DC boost converter 4 to the operating state when there is a commercial power source 50 outage and DC is output from the rechargeable batteries 1 to the input power supply lines 23. A DC/DC boost converter 4 that has been switched to the operating state steps-up the rechargeable battery 1 voltage and supplies power to the server input power supply lines 23 to maintain server operation.

Note the DC/DC boost converter 4 does not switch to the operational state by detecting voltage drop in the server power supply lines 23 due to commercial power source 50 outage. Rather, the charging and discharging control circuit 5 switches the DC/DC boost converter 4 to the operational state when power outage is detected. Accordingly, the uninterruptible power supply 10 is provided with a power-out detection circuit 6 that detects commercial power source 50 outage.

The charging and discharging control circuit 5 quickly detects commercial power source 50 outage and promptly switches the DC/DC boost converter 4 to the operating state. When commercial power source 50 outage occurs and the input power supply line 23 prescribed voltage cannot be maintained, the main server block 20 cannot be maintained in a stable operating state. During power outage, before the voltage of the power supply lines 23 drops to a set voltage, the uninterruptible power supply 10 switches the DC/DC boost converter 4 to the operating state to supply power from the rechargeable batteries 1 to the input power supply lines 23. Specifically, before the input power supply line 23 voltage drops to the minimum voltage for normal server operation, the charging and discharging control circuit 5 switches the DC/DC boost converter 4 to the operating state to supply power from the rechargeable batteries 1 to the server input power supply lines 23 and maintain the server in the operating state even after power outage. During power outage, the activated DC/DC boost converter 4 supplies operating power from the rechargeable batteries 1 to the server input power supply lines 23. In this state, the server performs designated processing including shutdown operations and then powers-down. The rechargeable batteries 1 supply operating voltage to the input power supply lines 23 until the server has completed the designated processing including shutdown. After the server has completed the designated processing and switched power OFF, the charging and discharging control circuit 5 stops DC/DC boost converter 4 operation, or the charging and discharging control circuit 5 stops DC/DC boost converter 4 operation when rechargeable battery 1 remaining capacity drops below the minimum capacity.

After power outage has been detected, the charging and discharging control circuit 5 also switches the DC/DC step-down converter 3 to a non-operating (inactive) state. Since the output of the DC/DC step-down converter 3 is fairly small compared to the output of the DC/DC boost converter 4, its no-load power consumption is small. For example, a DC/DC step-down converter 3 that charges 43V rechargeable batteries 1 with 1A has a rather small power specification of 43W. Accordingly, the no-load power consumption of the DC/DC step-down converter 3 is quite small. For example, even if 10% of the specified power is consumed under no-load conditions, the consumed power is no more than 4.3W. However, if this DC/DC step-down converter 3 is in the operating state during power outage, regardless of the small amount of power consumed, it still consumes power. Furthermore, since the DC/DC step-down converter 3 is not put in an operational state to charge the rechargeable batteries 1 during a power outage, the charging and discharging control circuit 5 switches the DC/DC step-down converter 3 to a non-operating state when power outage is detected. However, since the time the server is supplied with power during power outage is a short period such as 2min to 10min, it is also possible to leave the DC/DC step-down converter 3 in the operating state during that time period.

Although not illustrated, the power-out detection circuit 6 shifts the phase of the commercial power source 50 AC by 90° with an integrating circuit or differentiating circuit to generate a phase-shifted signal. The phase-shifted signal and the AC signal input from the commercial power source 50 are both squared by separate squaring circuits, and adding the separate squaring circuit outputs in an adder circuit allows commercial power source 50 outage to be quickly detected. When the AC signal input from the commercial power source 50 to the power-out detection circuit 6 is Asinω, a DC voltage of A² is output by implementing the equation below. In other words, AC is input and DC is output.
(Asinrω)²+(Acosω)²=A²
In this equation, A is the peak voltage of the commercial power source 50 signal. In this power-out detection circuit 6, the adder circuit outputs a constant DC voltage (A²) when power is input from the commercial power source 50. However, when power outage occurs and the commercial power source 50 input waveform varies from sinusoidal, the output voltage immediately changes allowing power outage to be detected. Specifically, power outage is detected by instantaneously determining whether or not the commercial power source 50 input varies according to a sine-wave with a given period and amplitude (voltage). If the power-out detection circuit 6 detects commercial power source 50 outage, it outputs a power-out-signal to the charging and discharging control circuit 5.

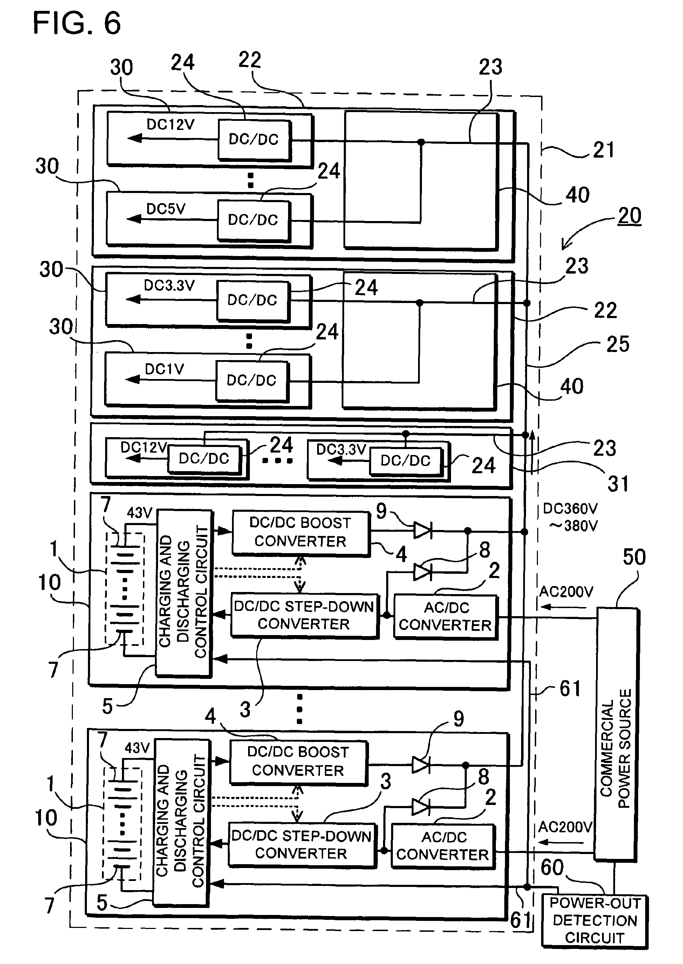

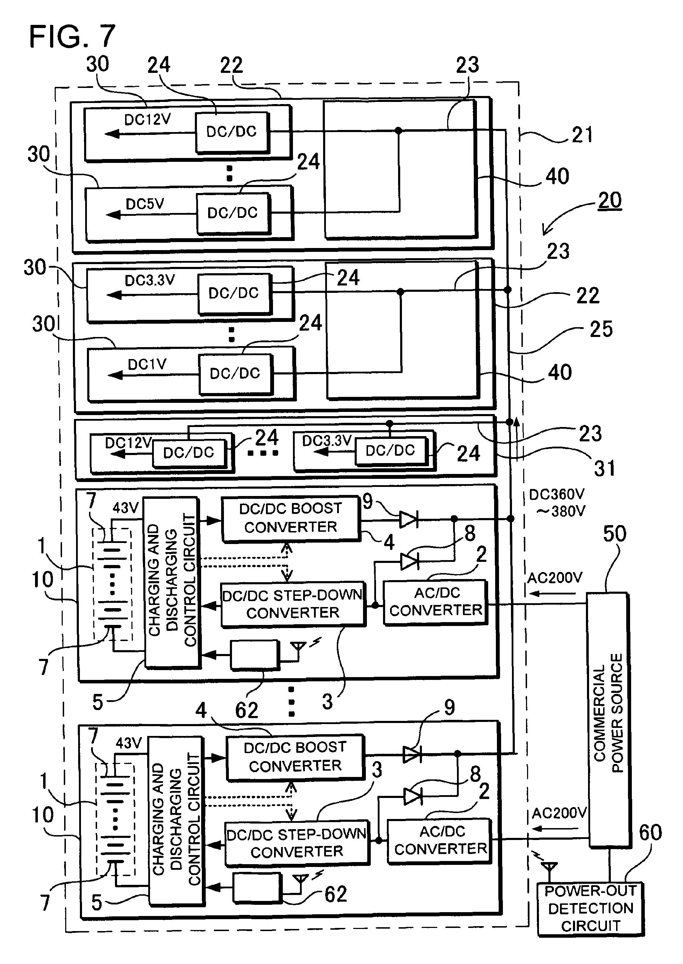

The uninterruptible power supply 10 shown in Fig. 5 houses a power-out detection circuit 6 that detects commercial power source 50 outage. The power-out detection circuit 6 detects power outage from the waveform input from the commercial power source 50 and issues a power-out-signal to the charging and discharging control circuit 5. However, the power-out detection circuit does not necessarily have to be housed inside the uninterruptible power supply. The power-out detection circuit can be provided outside the uninterruptible power supply to output power-out-signals to each uninterruptible power supply and detect commercial power outage. As shown in Figs. 6 and 7, this power-out detection circuit 60 can be directly connected to the commercial power source 50 to detect power outage. Although not illustrated, this power-out detection circuit 60 is connected to a commercial power source 50 outlet via a plug. The power-out detection circuit 60 issues a power-out-signal when commercial power source 50 outage is detected. As shown in Fig. 6, the power-out-signal from the power-out detection circuit 60 is input to an uninterruptible power supply 10 charging and discharging control circuit 5 via communication line 61 wires. Or, as shown in Fig. 7, the power-out-signal is sent to an uninterruptible power supply 10 charging and discharging control circuit 5 as a wireless signal. Each uninterruptible power supply 10 of Fig. 7 houses a receiver 62 to receive a wireless signal sent from the power-out detection circuit 60, and each receiver 62 receives a wireless signal and inputs it to the charging and discharging control circuit 5. However, although not illustrated, the wireless signal sent from the power-out detection circuit can also be received at the server, and subsequently sent to uninterruptible power supply charging and discharging control circuits via communication lines. ln the configurations described above, a power-out detection circuit is not provided in each uninterruptible power supply, but rather commercial power outage can be transmitted to a plurality of uninterruptible power supplies by power-out-signals from a single power-out detection circuit.

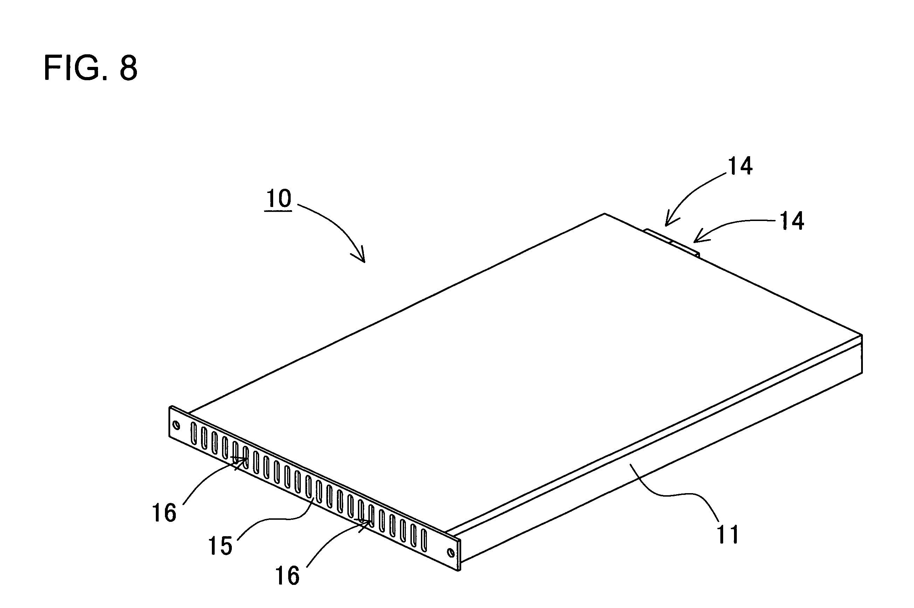

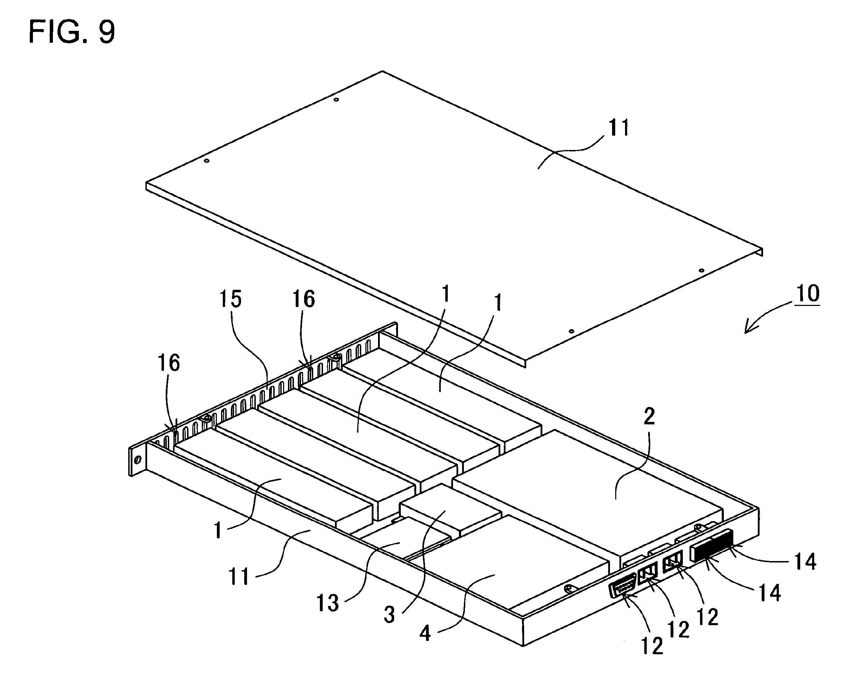

Figs. 8 and 9 show an uninterruptible power supply 10. This uninterruptible power supply 10 houses rechargeable batteries 1 made up of a plurality of battery cells 7 in the front part of the external case 11, and houses the AC/DC converter 2, the DC/DC step-down converter 3, and the DC/DC boost converter 4 in the back part. The charging and discharging control circuit 5 is mounted on an internally housed circuit board 13. The uninterruptible power supply 10 of the figures is provided with cooling fans 14 at the back end of the external case 11, and heat generating elements such as switching device field effect transistors (FETs) in the AC/DC converter 2, in the DC/DC step-down converter 3, and in the DC/DC boost converter 4, rectifying diodes, and rechargeable batteries 1 are cooled by cooling fan 14 forced ventilation. The external case 11 is provided with a front panel 15 having numerous openings 16 to pass air ingested or discharged by the cooling fans 14 at the back of the external case 11. The air inside this uninterruptible power supply 10 is cooled by forced ventilation with the cooling fans 14 allowing uninterruptible power supply 10 temperature rise to be reduced.

## Claims

1. A server comprising:
a main server block (20) that holds a plurality of blade servers (30) and/or rack servers (31) in a server case (21); and
an uninterruptible power supply (10) housed in the server case (21) of the main server block (20) that supplies 150V-400V DC operating power to the main server block (20) input power supply lines (23) both when commercial power source (50) power outage occurs and when there is no power outage,
**characterized in that**
the uninterruptible power supply (10) comprises:
rechargeable batteries (1) with a voltage specification of 60V or less that supply operating power to the main server block (20) during commercial power source (50) outage;
an AC/DC converter (2) that converts power input from an external commercial power source (50) to DC, supplies charging power to the rechargeable batteries (1), and supplies DC power to the main server block (20) input power supply lines (23);
a DC/DC step-down converter (3) that steps-down the AC/DC converter (2) output voltage to the rechargeable battery (1) charging voltage;
a DC/DC boost converter (4) with constant voltage characteristics that steps-up the rechargeable battery (1) voltage and supplies power to the main server block (20) input power supply lines (23) during power outage; and
a charging and discharging control circuit (5) that detects commercial power source (50) outage and switches the DC/DC boost converter (4) to the operating state,
wherein when there is no commercial power source (50) outage, operating power is supplied to the main server block (20) input power supply lines (23) from the AC/DC converter (2), and
wherein when commercial power source (50) outage occurs, the charging and discharging control circuit (5) detects power outage and puts the DC/DC boost converter (4) in the operating state to supply operating power from the rechargeable batteries (1) to the main server block (20) input power supply lines (23).

2. The server as cited in claim 1 provided with a plurality of uninterruptible power supplies (10), and the plurality of uninterruptible power supplies (10) are connected in parallel to the input power supply lines (23) to supply operating power to the plurality of blade servers (30) and/or rack servers (31).

3. The server as cited in claim 1 or claim 2 wherein the main server block (20) houses an uninterruptible power supply (10) in a removable manner in the bottom section of the server case (21).

4. The server as cited in any one of the claims 1-3 wherein the time that the uninterruptible power supply (10) maintains the server in an operational state after power outage occurs is longer than the time required to properly shutdown the server.

5. The server as cited in any one of the claims 1-4 wherein the time that the uninterruptible power supply (10) maintains the server in an operational state after power outage occurs is 2min to 10min.

6. The server as cited in any one of the claims 1-5 wherein the backside of the server case (21) is provided with interconnect bays (40) that are connected to blade servers (30), rack servers (31), and uninterruptible power supplies (10) loaded in the server case (21); an uninterruptible power supply (10) is provided with a connecting section (12) that connects to an interconnect bay (40) when the uninterruptible power supply (10) is loaded in a designated position; and the uninterruptible power supplies (10) are connected to the interconnect bays (40) via the connecting sections (12).

7. The server as cited in any one of the claims 1-6 provided with DC/DC converters (24) that convert the 150V-400V DC supplied to the input power supply lines (23) to the power supply voltages of the main server block (20).

8. The server as cited in any one of the claims 2-7 wherein a power-out detection circuit (60) is provided outside the uninterruptible power supplies (10) and power-out-signals from the power-out detection circuit (60) are output to each uninterruptible power (10) supply to detect commercial power outage.

9. A server uninterruptible power supply housed in the server case (21) of the main server block (20), which holds a plurality of blade servers (30) and/or rack servers (31); the uninterruptible power supply supplies 150V-400V DC operating power to the main server block (20) input power supply lines (23) both when commercial power source (50) power outage occurs and when there is no power outage; the uninterruptible power supply comprising:
rechargeable batteries (1) with a voltage specification of 60V or less that supply operating power to the main server block (20) during commercial power source (50) outage;
an AC/DC converter (2) that converts power input from an external commercial power source (50) to DC, supplies charging power to the rechargeable batteries (1), and supplies DC power to the main server block (20) input power supply lines (23);
a DC/DC step-down converter (3) that steps-down the AC/DC converter (2) output voltage to the rechargeable battery (1) charging voltage;
a DC/DC boost converter (4) with constant voltage characteristics that steps-up the rechargeable battery (1) voltage and supplies power to the main server block (20) input power supply lines (23) during power outage; and
a charging and discharging control circuit (5) that detects commercial power source (50) outage and switches the DC/DC boost converter (4) to the operating state,
**characterized in that**
when there is no commercial power source (50) outage, operating power is supplied to the main server block (20) input power supply lines (23) from the AC/DC converter (2), and
when commercial power source (50) outage occurs, the charging and discharging control circuit (5) detects power outage and puts the DC/DC boost converter (4) in the operating state to supply operating power from the rechargeable batteries (1) to the main server block (20) input power supply lines (23).

10. The server uninterruptible power supply as cited in claim 9 wherein the AC/DC converter (2) is a power supply circuit having constant-voltage, constant―current characteristics.

11. The server uninterruptible power supply as cited in claim 9 or claim 10 wherein the AC/DC converter (2) has a reverse-current protection diode (8) connected to the output-side leading to the input power supply lines (23).

12. The server uninterruptible power supply as cited in any one of the claims 9-11 wherein the DC/DC boost converter (4) has constant-voltage, constant-current characteristics to stabilize output voltage to a constant voltage and limit output current to a constant current.

13. The server uninterruptible power supply as cited in any one of the claims 9-12 wherein the DC/DC boost converter (4) has a reverse-current protection diode (9) connected to the output-side.

14. The server uninterruptible power supply as cited in any one of the claims 9-13 wherein during power outage when the rechargeable batteries (1) are discharging to supply power to the server and remaining rechargeable batteries (1) capacity drops to a minimum capacity, the charging and discharging control circuit (5) stops DC/DC boost converter (4) operation to stop rechargeable battery (1) discharge.

15. The server uninterruptible power supply as cited in any one of the claims 9-14 provided with a power-out detection circuit (6) that detects commercial power source (50) outage; when the power-out detection circuit (6) detects power outage, the charging and discharging control circuit (5) switches the DC/DC boost converter (4) to the operational state.

16. The server uninterruptible power supply as cited in any one of the claims 9-15 wherein during power outage, before the voltage of the power supply lines (23) drops to the minimum voltage for normal server operation, the charging and discharging control circuit (5) switches the DC/DC boost converter (4) to the operating state to supply power from the rechargeable batteries (1) to the input power supply lines (23) and maintain the server in the operating state even after power outage.
